# EUROPEAN PATENT APPLICATION

(11) **EP 4 730 391 A2**
(43) Date of publication of application: **22.04.2026**
(21) Application number: 25204751.9
(22) Date of filing: 25.09.2025
(51) Int. Cl.: H01J 37/32

(54) **SUBSTRATE PROCESSING APPARATUS, METHOD OF ADJUSTING ELECTROMAGNETIC WAVE SHIELD, METHOD OF MANUFACTURING SEMICONDUCTOR DEVICE AND PROGRAM**

(30) Priority: 17.10.2024 JP 2024182001
(71) Applicant: Kokusai Electric Corp., Tokyo 1010045 (JP)
(72) Inventor: SAKURAI, Tasuku, Toyama-shi, 939-2393 (JP); UEDA, Tsuyoshi, Toyama-shi, 939-2393 (JP); MUROBAYASHI, Masaki, Toyama-shi, 939-2393 (JP)
(74) Representative: Verscht, Thomas Kurt Albert

(57) **Abstract**

It is possible to prevent a leakage of an electromagnetic wave. There is provided a technique that includes: a vessel in which a substrate is processed; a plasma generator including: an electrode provided on an outer periphery of the vessel; a power supply line connected to the electrode; and a supplier configured to supply a high frequency power to the electrode via the power supply line; a shield provided on an outer periphery of the electrode and configured to shield an electromagnetic wave emitted from the electrode; an opening provided at the shield, wherein the power supply line is inserted through the opening; a plurality of shielding structures provided to overlap with one another around the opening and around locations of the supplier facing the opening; and a controller configured to be capable of controlling the plasma generator to move relative to the shield.

## Description

### [Technical Field]

The present disclosure relates to a substrate processing apparatus, a method of adjusting an electromagnetic wave shield, a method of manufacturing a semiconductor device and a program.

### [Related Art]

As a part of a manufacturing process of a semiconductor device, a process of modifying a film formed on a substrate by using a plasma may be performed (see, for example, Patent Document 1).

### [Related Art Document]

### [Patent Document]

Patent Document 1: Japanese Patent Laid-Open No. 2014-75579

### [Disclosure]

### [Technical Problem]

According to the present disclosure, there is provided a technique capable of preventing a leakage of an electromagnetic wave.

According to an embodiment of the present disclosure, there is provided a technique that includes: a vessel in which a substrate is processed; a plasma generator including: an electrode provided on an outer periphery of the vessel, wherein a high frequency power is applied to the electrode; a power supply line connected to the electrode; and a supplier configured to supply the high frequency power to the electrode via the power supply line; a shield provided on an outer periphery of the electrode and configured to shield an electromagnetic wave emitted from the electrode; an opening provided at the shield, wherein the power supply line is inserted through the opening; a plurality of shielding structures provided to overlap with one another around the opening and around locations of the supplier facing the opening; and a controller configured to be capable of controlling the plasma generator to move relative to the shield.

### [Advantageous Effects]

According to some embodiments of the present disclosure, it is possible to prevent a leakage of an electromagnetic wave.

### [Brief Description of Drawings]

FIG. 1 is a diagram schematically illustrating a configuration of a substrate processing apparatus according to one or more embodiments of the present disclosure.
FIG. 2 is a diagram schematically illustrating a plasma generator according to the embodiments of the present disclosure.
FIG. 3 is a block diagram schematically illustrating a configuration of a controller and its related components of the substrate processing apparatus according to the embodiments of the present disclosure.
FIG. 4 is a flow chart schematically illustrating a substrate processing according to the embodiments of the present disclosure.

### [Detailed Description]

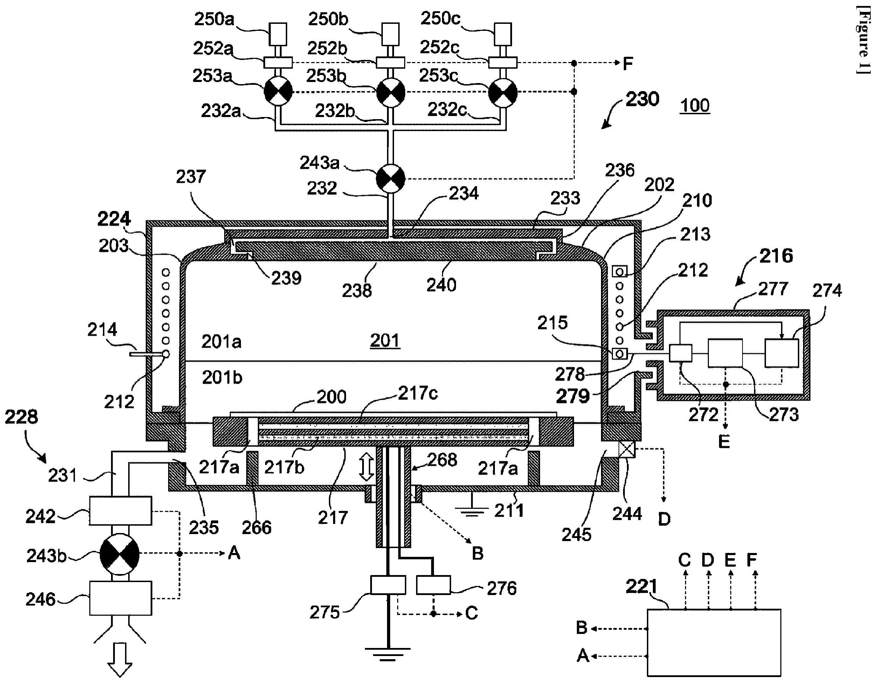

Hereinafter, one or more embodiments (hereinafter, also simply referred to as "embodiments") according to the present disclosure will be described with reference to FIGS. 1 to 4. For example, the drawings used in the following descriptions are all schematic, and a relationship between dimensions of each component and a ratio of each component shown in the drawing may not always match the actual ones. In addition, even between the drawings, the relationship between the dimensions of each component and the ratio of each component may not always match.

### (1) Configuration of Substrate Processing Apparatus

As shown in FIG. 1, a substrate processing apparatus 100 includes a process furnace 202 in which a wafer 200 serving as a substrate is processed by a plasma. The process furnace 202 is provided with a process vessel 203 serving as a vessel constituting a process chamber 201. That is, the substrate processing apparatus 100 is configured to process the wafer 200 by the plasma in the process vessel 203. The process vessel 203 is provided with an upper vessel 210 of a dome shape and a lower vessel 211 of a bowl shape.

By covering the lower vessel 211 with the upper vessel 210, the process chamber 201 is defined. For example, the upper vessel 210 is made of quartz (SiO₂). For example, the lower vessel 211 is made of aluminum (Al).

In addition, as shown in FIG. 1, a gate valve 244 is provided on a lower side wall of the lower vessel 211. While the gate valve 244 is open, the wafer 200 can be transferred (loaded) into the process chamber 201 through a loading/unloading port 245 using a wafer transfer structure (not shown) or can be transferred (unloaded) out of the process chamber 201 through the loading/unloading port 245 using the wafer transfer structure. While the gate valve 244 is closed, the gate valve 244 functions as a gate valve capable of maintaining the process chamber 201 airtight.

The process chamber 201 may include a plasma generation space 201a and a substrate processing space 201b. A resonance coil 212 serving as an electrode is provided around the plasma generation space 201a. The substrate processing space 201b communicates with the plasma generation space 201a, and serves as a space where the wafer 200 is processed. The plasma generation space 201a refers to a space in which the plasma is generated, for example, a space above a lower end of the resonance coil 212 and below an upper end of the resonance coil 212 in the process chamber 201. In addition, the substrate processing space 201b refers to a space in which the wafer 200 is processed by using the plasma, for example, a space below the lower end of the resonance coil 212.

### <Susceptor 217>

As shown in FIG. 1, a susceptor 217 serving as a substrate mounting table on which the wafer 200 is placed is provided at a center of a lower portion of the process chamber 201.

A heater 217b serving as a heating structure is integrally embedded in the susceptor 217.

The susceptor 217 is electrically insulated from the lower vessel 211. An impedance adjusting electrode 217c is provided in the susceptor 217. The impedance adjusting electrode 217c is grounded via a variable impedance regulator 275 serving as an impedance regulator (which is an impedance adjusting structure).

A susceptor elevator (which is a susceptor elevating structure) 268 including a driver (which is a driving structure: not shown) capable of elevating and lowering the susceptor 217 is provided at the susceptor 217. In addition, through-holes 217a are provided at the susceptor 217, and wafer lift pins 266 are provided at a bottom surface of the lower vessel 211 at locations corresponding to the through-holes 217a. When the susceptor 217 is lowered by the susceptor elevator 268, the wafer lift pins 266 pass through the through-holes 217a without contacting the susceptor 217.

A substrate mounting structure according to the present embodiments is constituted mainly by the susceptor 217 and the heater 217b.

### <Gas Supplier 230>

As shown in FIG. 1, a gas supplier (which is a gas supply system) 230 is provided above the process chamber 201. Specifically, a gas supply head 236 is provided above the process chamber 201, that is, on an upper portion of the upper vessel 210. The gas supply head 236 may include a lid 233 of a cap shape, a gas inlet port 234, a buffer chamber 237, an opening 238, a shield plate 240 and a gas outlet port 239, and is configured such that gases are capable of being supplied into the process chamber 201 through the gas supply head 236.

A gas supply pipe 232 is connected to the gas inlet port 234. A downstream end of a first gas supply pipe 232a through which a first gas is supplied, a downstream end of a second gas supply pipe 232b through which a second gas is supplied and a downstream end of an inert gas supply pipe 232c through which an inert gas is supplied are connected to the gas supply pipe 232 so as to be conjoined with one another.

A mass flow controller (MFC) 252a serving as a flow rate controller and a valve 253a serving as an opening/closing valve are sequentially provided at the first gas supply pipe 232a in this order from an upstream side to a downstream side of the first gas supply pipe 232a in a gas flow direction. An MFC 252b and a valve 253b are sequentially provided at the second gas supply pipe 232b in this order from an upstream side to a downstream side of the second gas supply pipe 232b in the gas flow direction. An MFC 252c and a valve 253c are sequentially provided at the inert gas supply pipe 232c in this order from an upstream side to a downstream side of the inert gas supply pipe 232c in the gas flow direction. Although not included in the substrate processing apparatus 100, a first gas supply source 250a is provided at the first gas supply pipe 232a at an upstream side of the MFC 252a, a second gas supply source 250b is provided at the second gas supply pipe 232b at an upstream side of the MFC 252b, and an inert gas supply source 250c is provided at the inert gas supply pipe 232c at an upstream side of the MFC 252c.

A valve 243a is provided at the gas supply pipe 232. The gas supplier 230 is configured to be capable of supplying the gases used for processing the wafer 200 into the process vessel 203.

The gas supplier (gas supply system) 230 according to the present embodiments is constituted mainly by the gas supply head 236 (that is, the lid 233, the gas inlet port 234, the buffer chamber 237, the opening 238, the shield plate 240 and the gas outlet port 239), the first gas supply pipe 232a, the second gas supply pipe 232b, the inert gas supply pipe 232c, the MFCs 252a, 252b and 252c and the valves 253a, 253b, 253c and 243a. The gas supplier 230 may further include the first gas supply source 250a, the second gas supply source 250b and the inert gas supply source 250c.

### <Exhauster 228>

A gas exhaust port 235 through which the gas in the process chamber 201 is exhausted is provided on a side wall of the lower vessel 211. An upstream end of a gas exhaust pipe 231 is connected to the gas exhaust port 235. An APC (Automatic Pressure Controller) valve 242 serving as a pressure regulator (pressure adjusting structure), a valve 243b serving as an opening/closing valve and a vacuum pump 246 serving as a vacuum exhaust apparatus are sequentially provided at the gas exhaust pipe 231 in this order from an upstream side to a downstream side of the gas exhaust pipe 231 in the gas flow direction.

An exhauster (which is an exhaust system) 228 according to the present embodiments is constituted mainly by the gas exhaust port 235, the gas exhaust pipe 231, the APC valve 242 and the valve 243b. In addition, the exhauster 228 may further include the vacuum pump 246.

### <Plasma Generator 216>

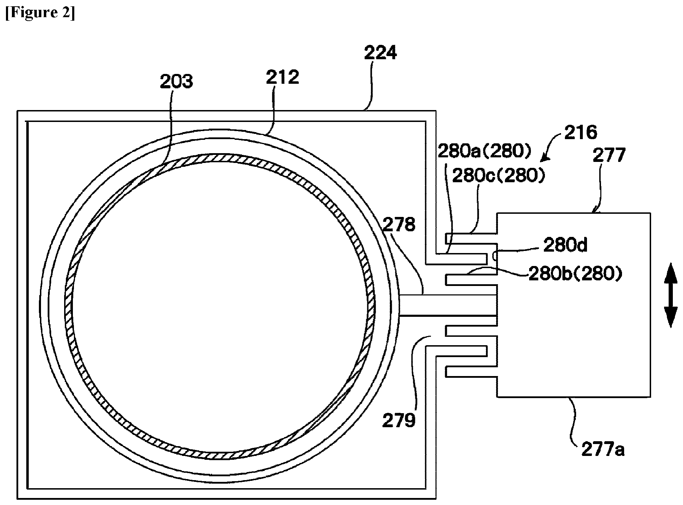

As shown in FIGS. 1 and 2, the resonance coil 212 to which a high frequency power is applied is provided on an outer periphery of the process vessel 203, that is, on an outside of an outer wall of the process vessel 203. Specifically, the resonance coil 212 of a spiral shape is provided on an outside of a side wall of the upper vessel 210 so as to surround the process chamber 201. In other words, the resonance coil 212 of a spiral shape is provided so as to surround the process vessel 203 outside the upper vessel 210 along a radial direction of the upper vessel 210 away from a center of the upper vessel 210.

In addition, an RF (Radio Frequency) sensor 272, a high frequency power supply 273 and a matcher (which is a matching structure) 274 configured to match an impedance and an output frequency of the high frequency power supply 273 are connected to the resonance coil 212 via a power supply line 278.

The high frequency power supply 273 is configured to supply the high frequency power (RF power) to the resonance coil 212. The RF sensor 272 is provided at an output side of the high frequency power supply 273, and is configured to monitor information of a traveling wave or reflected wave of the high frequency power supplied from the high frequency power supply 273. The information of the reflected wave monitored by the RF sensor 272 is input to the matcher 274. Based on the information of the reflected wave, the matcher 274 is configured to control the impedance or the output frequency of the high frequency power supply 273 so as to minimize an amplitude of the reflected wave.

The high frequency power supply 273 may include a power supply controller (which is a control circuit) (not shown) and an amplifier (which is an output circuit) (not shown). The power supply controller may include a high frequency oscillation circuit (not shown) and a preamplifier (not shown) in order to regulate an oscillation frequency and an output. The amplifier amplifies the output to a predetermined output level. The power supply controller controls the amplifier based on output conditions relating to its frequency and its power, which are set in advance through an operation panel (not shown). The amplifier is configured to supply a constant high frequency power to the resonance coil 212 via a transmission line.

A winding diameter, a winding pitch and the number of winding turns of the resonance coil 212 are set such that the resonance coil 212 resonates at a constant wavelength to form the standing wave of a predetermined wavelength. That is, an electrical length of the resonance coil 212 is set to a length corresponding to an integral multiple (1 time, 2 times, or so on) of a wavelength of a predetermined frequency of the high frequency power supplied from the high frequency power supply 273. In other words, the substrate processing apparatus 100 is provided with the high frequency power supply 273 such that the high frequency power can be supplied to the resonance coil 212 (electrode) whose electrical length is the integral multiple of the wavelength of the predetermined frequency of the high frequency power.

For example, as a material constituting the resonance coil 212, a copper pipe, a copper thin plate, an aluminum pipe, an aluminum thin plate, or a material obtained by depositing copper, or aluminum on a polymer belt may be used.

Both ends of the resonance coil 212 are electrically grounded. At least one end of the resonance coil 212 is grounded via a movable tap 213 in order to fine-tune the electrical length of the resonance coil 212 when the substrate processing apparatus 100 is newly installed or process conditions of the substrate processing apparatus 100 are changed. A reference numeral 214 shown in FIG. 1 indicates a fixed ground at the other end of the resonance coil 212. In addition, a power feeder (not shown) constituted by a movable tap 215 is provided between the grounded both ends of the resonance coil 212 in order to fine-tune the impedance of the resonance coil 212.

The power supply line 278 through which the high frequency power is supplied to the resonance coil 212 is connected to the movable tap 215.

The power supply line 278 is of a plate shape, and for example, is made of a material containing copper. Specifically, the power supply line 278 is configured as a copper-containing plate whose width is, for example, within a range from 50 mm to 60 mm and whose thickness is, for example, about 1 mm. In the present specification, a notation of a numerical range such as "from 50 mm to 60 mm" means that a lower limit and an upper limit thereof are included in the numerical range. Therefore, for example, the numerical range "from 50 mm to 60 mm" means a range equal to or higher than 50 mm and equal to or lower than 60 mm. The same also applies to other numerical ranges described herein.

The RF sensor 272, the high frequency power supply 273 and the matcher 274 are accommodated in a housing 277a. The RF sensor 272, the high frequency power supply 273 and the matcher 274 are used as a supplier (which is a supply system) 277 configured to supply the high frequency power to the resonance coil 212 through the power supply line 278. The supplier 277 is provided outside the process vessel 203.

The plasma generator 216 according to the present embodiments is constituted mainly by the resonance coil 212, the power supply line 278 and the supplier 277.

As shown in FIG. 1, for example, a shield 224 is provided around an outer periphery of the resonance coil 212 to cover the resonance coil 212 and to shield (or block) an electromagnetic wave emitted from the resonance coil 212. In addition, the shield 224 is provided to form a capacitive component (also referred to as a "C component") of the resonance coil 212 for constructing a resonance circuit between the shield 224 and the resonance coil 212. The C component serves as a part of components of the resonance circuit.

Specifically, the shield 224 is formed using a conductive material such as an aluminum alloy. A lower end portion of the shield 224 is configured to be installed on an upper end portion formed around the lower vessel 211.

At a side surface of the shield 224, an opening 279 through which the power supply line 278 is inserted is provided. The opening 279 is configured such that a width of the opening 279 is set to be wider than a width of the power supply line 278.

Around a periphery of the opening 279, an opening shielding structure 280a is provided as a shield. The opening shielding structure 280a is configured to extend along the power supply line 278 toward the supplier 277. In other words, the opening shielding structure 280a is configured to cover a periphery of the power supply line 278.

In addition, around a position (location) of the supplier 277 facing the opening 279, a power supply shielding structure 280b serving as a first power supply shielding structure and a power supply shielding structure 280c serving as a second power supply shielding structure are provided. Each of the power supply shielding structure 280b and the power supply shielding structure 280c is configured as a part of the housing 277a constituting the supplier 277. A shielding structure 280 is constituted by the opening shielding structure 280a, the power supply shielding structure 280b and the power supply shielding structure 280c.

The power supply shielding structure 280b is configured to extend toward the opening 279 along the power supply line 278. The power supply shielding structure 280b is configured to be provided inside the opening shielding structure 280a and to be surrounded by an inner surface of the opening shielding structure 280a.

The power supply shielding structure 280c is configured to extend toward the shield 224 along the power supply line 278. The power supply shielding structure 280c is configured to be provided outside the opening shielding structure 280a and to surround an outer surface of the opening shielding structure 280a.

In other words, the power supply shielding structure 280b and the power supply shielding structure 280c are arranged with a gap therebetween. Thereby, it is possible to move the supplier 277 in a horizontal direction (a front-rear direction in FIG. 1 and an up-down direction in FIG. 2).

In other words, the power supply shielding structure 280b and the power supply shielding structure 280c are configured to cover the inner and outer surfaces of the opening shielding structure 280a such that the opening shielding structure 280a is interposed between the power supply shielding structure 280b and the power supply shielding structure 280c. A wall surface 280d between the power supply shielding structure 280b and the power supply shielding structure 280c of the housing 277a functions as a shield capable of shielding the electromagnetic wave. In other words, the shielding structure 280 may further include the wall surface 280d.

That is, the opening shielding structure 280a is configured to be arranged outside the power supply shielding structure 280b and inside the power supply shielding structure 280c. In other words, the opening shielding structure 280a and the power supply shielding structures 280b and 280c are provided so as to alternately overlap with one another. By providing the shielding structures 280a, 280b and 280c so as to overlap with one another substantially parallel to the power supply line 278 in a manner described above, the electromagnetic wave leaking from the power supply line 278 can be reflected and attenuated by the shielding structures 280a, 280b and 280c and the wall surface 280d. As a result, it is possible to prevent the leakage of the electromagnetic wave. At this time, it is preferable to increase an overlapping area between the opening shielding structure 280a and the power supply shielding structures 280b and 280c, that is, to increase a spatial range in which the opening shielding structure 280a and the power supply shielding structures 280b and 280c are alternately overlapped with one another. Thereby, it is possible to increase an amount of attenuation of the electromagnetic wave leaking from the power supply line 278, and it is also possible to prevent the leakage of the electromagnetic wave.

A mover (which is a moving structure) 281 configured to move the plasma generator 216 as an integrated body is connected to the plasma generator 216. In addition, the opening shielding structure 280a is configured such that a position of the opening shielding structure 280a relative to the plasma generator 216 is fixed. In other words, the shield 224 is configured such that a position of the shield 224 relative to the plasma generator 216 is fixed.

In other words, the plasma generator 216 is configured to be capable of being moved in the horizontal direction relative to the shield 224 (that is, the opening shielding structure 280a). Therefore, it is possible to move the power supply shielding structures 280b and 280c with respect to the opening shielding structure 280a, and it is also possible to adjust each gap between the power supply shielding structures 280b and 280c and the opening shielding structure 280a. Thereby, it is possible to fine-tune the impedance while shielding a location where the leakage of the electromagnetic wave is occurring.

According to the present embodiments, a horizontal width of each gap formed between the power supply shielding structures 280b and 280c provided in the supplier 277 and the opening shielding structure 280a provided in the opening 279 is larger than a distance of a movement of the plasma generator 216 in a direction parallel to an opening surface of the opening 279. In other words, a horizontal movement amount (that is, an amount of a horizontal movement) of the plasma generator 216 is set to be smaller than the horizontal width of each gap formed between the power supply shielding structures 280b and 280c and the opening shielding structure 280a. As a result, even when the plasma generator 216 is moved by the mover 281, each gap is formed between the opening shielding structure 280a and the power supply shielding structures 280b and 280c.

In other words, the mover 281 is configured to be capable of moving the supplier 277, the power supply line 278 and the resonance coil 212 simultaneously and integrally in the horizontal direction with respect to the shield 224 in which the opening 279 is provided. In a manner described above, by configuring such that a power supply structure configured to supply the high frequency power to the resonance coil 212 is moved alone, it is possible to easily perform a control related thereto.

### <Controller 221>

As shown in FIG.1, a controller 221 serving as a control structure is configured to be capable of respectively controlling: the APC valve 242, the valve 243b and the vacuum pump 246 through a signal line "A"; the susceptor elevator 268 through a signal line "B"; and a heater power regulator 276 and the variable impedance regulator 275 through a signal line "C". In addition, the controller 221 is further configured to be capable of respectively controlling: the gate valve 244 through a signal line "D"; the RF sensor 272, the high frequency power supply 273, the matcher 274 and the mover 281 through a signal line "E"; and the MFCs 252a, 252b and 252c and the valves 253a, 253b, 253c and 243a through a signal line "F".

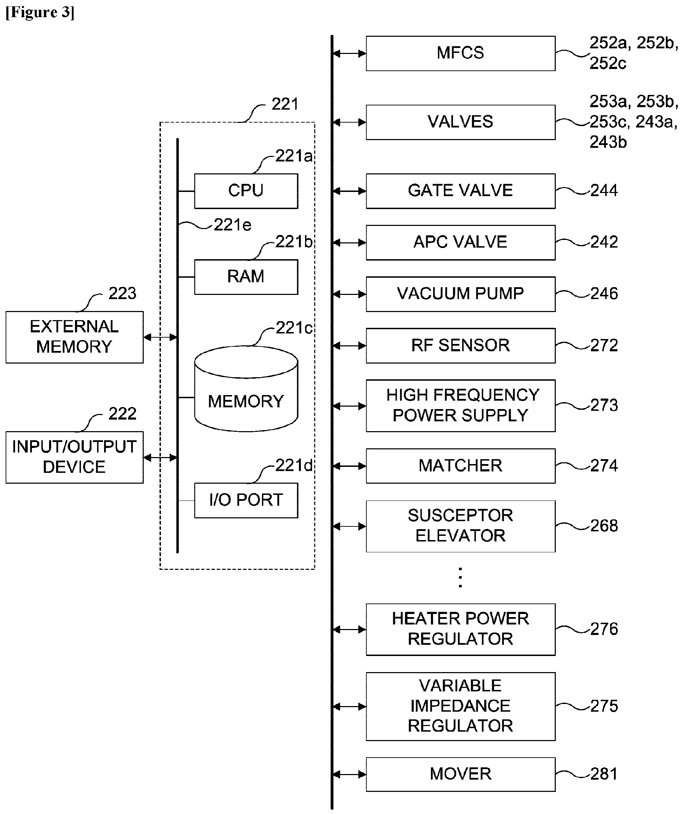

As shown in FIG. 3, the controller 221 is constituted by a computer including a CPU (Central Processing Unit) 221a, a RAM (Random Access Memory) 221b, a memory 221c and an I/O port (input/output port) 221d. The RAM 221b, the memory 221c and the I/O port 221d are configured to be capable of exchanging data with the CPU 221a through an internal bus 221e. For example, an input/output device 222 (which is constituted by components such as a touch panel and a display) may be connected to the controller 221.

According to the present embodiments, the input/output device 222 is configured to receive an input of an operation command and process conditions serving as movement information for moving the mover 281. In addition, the input/output device 222 is further configured to display an amount of a movement of the mover 281 with respect to a predetermined reference position.

Specifically, the input/output device 222 is used as a display provided with a screen through which a movement distance of the plasma generator 216 can be set, and also used as a manipulator through which the amount of the movement (also referred to as the "movement distance") of the plasma generator 216 can be set. That is, using the screen of the input/output device 222, it is possible to set a horizontal movement amount of the mover 281. That is, the CPU 221a is configured to be capable of displaying an output result on the input/output device 222, capable of setting the movement distance in the horizontal direction by an input from the input/output device 222, and capable of controlling the movement of the mover 281.

The memory 221c may be embodied by a component such as a flash memory and a hard disk drive (HDD). For example, a control program configured to control operations of the substrate processing apparatus 100, a process recipe in which information such as procedures and conditions of a substrate processing described later is stored, and a recipe execution program configured to execute the process recipe may be readably stored in the memory 221c.

The recipe execution program is obtained by combining steps (procedures) of the substrate processing described later such that the controller 221 can cause the CPU 221a to execute the steps to acquire a predetermined result, and functions as a program. Hereinafter, the recipe execution program and the control program may be collectively or individually referred to as a "program" or a "program product". Thus, in the present specification, the term "program" may refer to the recipe execution program alone, may refer to the control program alone, or may refer to both of the recipe execution program and the control program. In addition, the RAM 221b functions as a memory area (work area) where a program or data read by the CPU 221a is temporarily stored.

According to the present embodiments, each process condition is stored in the memory 221c. The process conditions include at least one among the following: a temperature of the wafer 200 to be processed, a pressure (inner pressure) of the process chamber 201, a type of gas used to process the wafer 200, a flow rate of the gas used to process the wafer 200, an electric power supplied to the resonance coil 212 and the horizontal movement amount of the plasma generator 216 by the mover 281.

The I/O port 221d is electrically connected to the components described above such as the MFCs 252a, 252b and 252c, the valves 253a, 253b and 253c, 243a and 243b, the gate valve 244, the APC valve 242, the vacuum pump 246, the RF sensor 272, the high frequency power supply 273, the matcher 274, the susceptor elevator 268, the heater power regulator 276, the variable impedance regulator 275 and the mover 281.

The CPU 221a is configured to read and execute the control program stored in the memory 221c, and to read the process recipe stored in the memory 221c in accordance with an instruction such as an operation command inputted via the input/output device 222.

The CPU 221a is further configured to be capable of controlling various operations, in accordance with the process recipe read from the memory 221c, such as an operation of adjusting an opening degree of the APC valve 242, an opening and closing operation of the valve 243b and a start and stop of the vacuum pump 246 via the I/O port 221d and the signal line "A". The CPU 221a is further configured to be capable of controlling various operations, in accordance with the process recipe read from the memory 221c, such as an elevating and lowering operation of the susceptor elevator 268 via the I/O port 221d and the signal line "B", a power supply amount adjusting operation (temperature adjusting operation) to the heater 217b by the heater power regulator 276 and the variable impedance regulator 275 via the I/O port 221d and the signal line "C", and an opening and closing operation of the gate valve 244 via the I/O port 221d and the signal line "D". The CPU 221a is further configured to be capable of controlling various operations, in accordance with the process recipe read from the memory 221c, such as controlling operations for the RF sensor 272, the matcher 274 and the high frequency power supply 273 and the moving operation of the mover 281 to move the plasma generator 216 via the I/O port 221d and the signal line "E", and flow rate adjusting operations for various gases by the MFCs 252a, 252b and 252c and opening and closing operations of the valves 253a, 253b, 253c and 243a via the I/O port 221d and the signal line "F".

Specifically, the CPU 221a is configured to be capable of controlling the plasma generator 216 to move in the horizontal direction with respect to the opening 279. For example, by moving the plasma generator 216 in a direction along which the electromagnetic wave is stronger in accordance with a directionality of the electromagnetic wave, it is possible to narrow each gap among the opening shielding structure 280a and the power supply shielding structures 280b and 280c. Thereby, it is possible to attenuate the electromagnetic wave.

The controller 221 may be configured by installing the above-mentioned program stored in an external memory 223 (for example, a magnetic tape, a magnetic disk such as a flexible disk and a hard disk, an optical disk such as a CD and a DVD and a semiconductor memory such as a USB memory and a memory card) into the computer. The memory 221c or the external memory 223 may be embodied by a non-transitory computer readable recording medium. Hereafter, the memory 221c and the external memory 223 may be collectively or individually referred to as a "recording medium". Thus, in the present specification, the term "recording medium" may refer to the memory 221c alone, may refer to the external memory 223 alone, or may refer to both of the memory 221c and the external memory 223. The program may be provided to the computer without using the external memory 223. For example, the program may be supplied to the computer using a communication interface such as the Internet and a dedicated line. For example, the program provided by using the communication interface such as the Internet and the dedicated line may be stored in the recording medium, and then the program stored in the recording medium may be supplied to the computer.

### (2) Substrate Processing

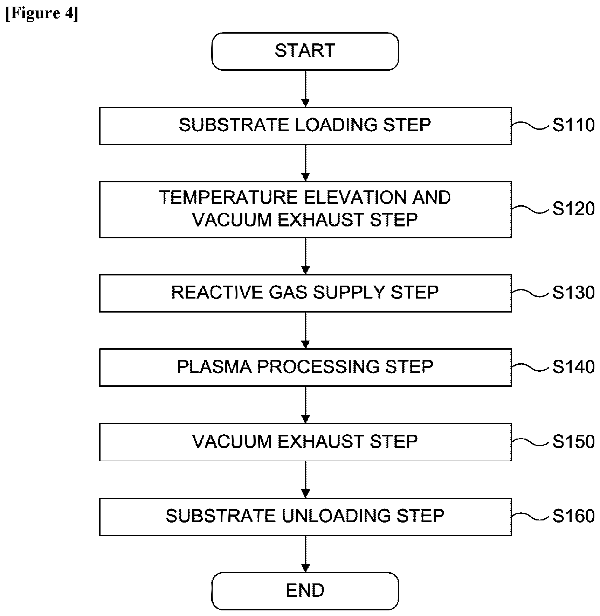

Hereinafter, an exemplary process sequence of the substrate processing (film-forming process) of forming a film containing a predetermined element on the wafer 200 will be described with reference to FIG. 4. The substrate processing serves as a part of a manufacturing process of a semiconductor device, and is performed by using the substrate processing apparatus 100 described above. In the following descriptions, operations of components constituting the substrate processing apparatus 100 are controlled by the controller 221.

### <Electromagnetic Wave Shield Adjusting Step>

First, the plasma generator 216 is moved relative to the shield 224 by the mover 281. Thereby, it is possible to adjust positions of the power supply shielding structures 280b and 280c with respect to the opening shielding structure 280a. In other words, a horizontal position of the plasma generator 216 is moved to a position at which the leakage of the electromagnetic wave from the resonance coil 212 and the power supply line 278 can be shielded (or blocked) while fine-tuning the impedance.

### <Substrate Loading Step S110>

In a substrate loading step S110, the wafer 200 is transferred (loaded) into the process chamber 201. Specifically, the susceptor 217 is lowered to a transfer position of the wafer 200 by the susceptor elevator 268 such that the wafer lift pins 266 pass through the through-holes 217a of the susceptor 217.

Subsequently, the gate valve 244 is opened, and the wafer 200 is loaded into the process chamber 201 using the wafer transfer structure (not shown) from a vacuum transfer chamber (not shown) provided adjacent to the process chamber 201. The wafer 200 loaded into the process chamber 201 is placed on and supported by the wafer lift pins 266 (which protrude from a surface of the susceptor 217) in a horizontal orientation. After the wafer 200 is loaded into the process chamber 201, the wafer transfer structure is retracted to a position outside the process chamber 201, and the gate valve 244 is closed to hermetically seal (or close) the process chamber 201. Thereafter, by elevating the susceptor 217 using the susceptor elevator 268, the wafer 200 is placed on and supported by an upper surface of the susceptor 217.

### <Temperature Elevation and Vacuum Exhaust Step S120>

In a temperature elevation and vacuum exhaust step S120, the temperature of the wafer 200 loaded into the process chamber 201 is elevated. The heater 217b is heated in advance, and the wafer 200 is heated by placing the wafer 200 on the susceptor 217 where the heater 217b is embedded. In the present step, the wafer 200 is heated such that the temperature of the wafer 200 reaches and is maintained at a target temperature. In addition, while the temperature of the wafer 200 is being elevated, the vacuum pump 246 vacuum-exhausts the process chamber 201 through the gas exhaust pipe 231 such that the inner pressure of the process chamber 201 reaches and is maintained at a predetermined pressure. The vacuum pump 246 is continuously operated at least until a substrate unloading step S160 described later is completed.

### <Reactive Gas Supply Step S130>

In a reactive gas supply step S130, as a supply of a reactive gas, a supply of the first gas and a supply of the second gas into the process chamber 201 are started. Specifically, the valve 253a and the valve 253b are opened to start the supply of the first gas and the supply of the second gas into the process chamber 201 while flow rates of the first gas and the second gas are adjusted by the MFCs 252a and 252b, respectively.

In addition, an exhaust of the process chamber 201 is controlled by adjusting the opening degree of the APC valve 242 such that the inner pressure of the process chamber 201 reaches and is maintained at a predetermined pressure. While appropriately exhausting the process chamber 201 in a manner described above, the first gas and the second gas are continuously supplied into the process chamber 201 until a plasma processing step S140 described later is completed.

As the first gas, for example, an oxygen-containing gas may be used. As the oxygen-containing gas, for example, a gas such as oxygen (O₂) gas may be used.

As the second gas, for example, a hydrogen-containing gas may be used. As the hydrogen-containing gas, for example, a gas such as hydrogen (H₂) gas may be used.

### <Plasma Processing Step S140>

After the inner pressure of the process chamber 201 is stabilized, in the plasma processing step S140, a supply (application) of the high frequency power to the resonance coil 212 from the high frequency power supply 273 via the RF sensor 272 are started.

Thereby, a high frequency electric field is formed (or provided) in the plasma generation space 201a to which the first gas and the second gas are supplied. By such an electric field, a donut-shaped induction plasma whose plasma density is the highest at a height position corresponding to an electrical midpoint of the resonance coil 212 in the plasma generation space 201a can be excited. Each of the first gas and the second gas is excited into a plasma state and dissociates. As a result, reactive species such as radicals (active species) and ions of elements contained in the first gas and the second gas can be generated. Specifically, reactive species such as oxygen radicals (oxygen active species) and oxygen ions containing oxygen, and hydrogen radicals (hydrogen active species) and hydrogen ions containing hydrogen are generated.

Then, the radicals and the ions generated by the induction plasma are supplied into a trench on the surface of the wafer 200 placed on the susceptor 217 in the substrate processing space 201b. Then, the radicals and the ions supplied into the trench react with a side wall of the trench. Thereby, a surface layer of the trench is modified. Specifically, for example, a silicon layer on a surface of the trench is modified into a silicon oxide layer.

After a predetermined process time has elapsed, the supply of the high frequency power from the high frequency power supply 273 is stopped to stop a plasma discharge in the process chamber 201. In addition, the valve 253a and the valve 253b are closed to stop the supply of the first gas and the supply of the second gas into the process chamber 201. Thereby, the plasma processing step S140 is completed. In the present specification, the term "process time" refers to a time (time duration) of continuously performing a process related thereto. The same also applies to the following description.

### <Vacuum Exhaust Step S150>

After the supply of the first gas and the supply of the second gas are stopped, in a vacuum exhaust step S150, the inside of the process chamber 201 is vacuum-exhausted through the gas exhaust pipe 231. Thereby, a gas such as the first gas, and the second gas and an exhaust gas generated from a reaction therebetween in the process chamber 201 can be exhausted out of the process chamber 201. Thereafter, the opening degree of the APC valve 242 is adjusted such that the inner pressure of the process chamber 201 is adjusted to the same pressure as that of the vacuum transfer chamber (to which the wafer 200 is to be transferred: not shown) provided adjacent to the process chamber 201.

### <Substrate Unloading Step S160>

After the inner pressure of the process chamber 201 is adjusted to a predetermined pressure, in the substrate unloading step S160, the susceptor 217 is lowered to the transfer position of the wafer 200 until the wafer 200 is supported by the wafer lift pins 266. Then, the gate valve 244 is opened, and the wafer 200 is transferred (unloaded) out of the process chamber 201 by using the wafer transfer structure (not shown). Thereby, the substrate processing according to the present embodiments is completed.

As described above, in the substrate processing apparatus 100, the electromagnetic wave leaking from the power supply line 278 can be attenuated by the shielding structures 280a, 280b and 280c respectively provided in the opening 279 and the supplier 277. Thereby, it is possible to prevent the leakage of the electromagnetic wave.

In addition, the present embodiments are described by way of an example in which the supplier 277 is moved in the horizontal direction to prevent the leakage of the electromagnetic wave. However, the present embodiments are not limited thereto. For example, the supplier 277 may be moved in a vertical direction (the up-down direction in FIG. 1). As a result, by moving the supplier 277 in the horizontal direction or the vertical direction, it is possible to further attenuate the electromagnetic wave leaking from the power supply line 278.

The present invention may be summarized as follows: It is possible to prevent a leakage of an electromagnetic wave. There is provided a technique that includes: a vessel in which a substrate is processed; a plasma generator including: an electrode provided on an outer periphery of the vessel; a power supply line connected to the electrode; and a supplier configured to supply a high frequency power to the electrode via the power supply line; a shield provided on an outer periphery of the electrode and configured to shield an electromagnetic wave emitted from the electrode; an opening provided at the shield, wherein the power supply line is inserted through the opening; a plurality of shielding structures provided to overlap with one another around the opening and around locations of the supplier facing the opening; and a controller configured to be capable of controlling the plasma generator to move relative to the shield.

### <Other Embodiments>

While the technique of the present disclosure is described in detail by way of the embodiments mentioned above, the technique of the present disclosure is not limited thereto. The technique of the present disclosure may be modified in various ways without departing from the scope thereof.

For example, the embodiments mentioned above are described by way of an example in which the opening shielding structure 280a is provided corresponding to the opening 279, and the power supply shielding structures 280b and 280c are provided corresponding to the supplier 277. However, the technique of the present disclosure is not limited thereto. For example, three or more shielding structures 280 may be provided corresponding to the supplier 277, a plurality of shielding structures 280 may be provided corresponding to the opening 279, or a plurality of shielding structures 280 may be provided corresponding to both of the opening 279 and the supplier 277. Even in such modified examples, it is possible to obtain substantially the same effects as in the embodiments mentioned above.

For example, the embodiments mentioned above are described by way of an example in which the electromagnetic wave shield adjusting step is performed before the substrate loading step S110. However, the technique of the present disclosure is not limited thereto. For example, the electromagnetic wave shield adjusting step may be performed before the plasma processing step 140 performed after the substrate loading step S110. Even in such a modified example, it is possible to obtain substantially the same effects as in the embodiments mentioned above.

In addition, while the technique of the present disclosure is described in detail by way of the embodiments and the modified examples mentioned above, the technique of the present disclosure is not limited thereto. It will be apparent to those skilled in the art that the technique of the present disclosure may be modified in various ways without departing from the scope thereof.

In addition, although not specifically described in the embodiments mentioned above, the number of each component described in the present specification is not limited to one, and the number of each component may be two or more unless otherwise specified in the present specification.

For example, the embodiments mentioned above are described by way of an example in which a single wafer type substrate processing apparatus capable of processing one or several substrates at once is used to form the film. However, the technique of the present disclosure is not limited thereto. For example, the technique of the present disclosure may be preferably applied when a batch type substrate processing apparatus capable of simultaneously processing a plurality of substrates is used to form the film. For example, the embodiments mentioned above are described by way of an example in which a substrate processing apparatus including a cold wall type process furnace is used to form the film. However, the technique of the present disclosure is not limited thereto. For example, the technique of the present disclosure may be preferably applied when a substrate processing apparatus including a hot wall type process furnace is used to form the film.

Process procedures and process conditions of each process using the substrate processing apparatuses exemplified above may be substantially the same as those of the embodiments or the modified examples mentioned above. Even in such a case, it is possible to obtain substantially the same effects as in the embodiments or the modified examples mentioned above.

In addition, the embodiments and the modified examples mentioned above may be appropriately combined. The process procedures and the process conditions of each combination thereof may be substantially the same as those of the embodiments mentioned above or the modified examples mentioned above.

### [Description of Reference Numerals]

| | | | |
|---|---|---|---|
| 100: | Substrate processing apparatus | 200: | Wafer (an example of a substrate) |
| 203: | Process vessel (an example of a vessel) | | |
| 212: | Resonance coil (an example of an electrode) | | |
| 216: | Plasma generator | 221: | Controller |
| 224: | Shield | 277: | Supplier |
| 278: | Power supply line | 279: | Opening |
| 280: | Shield | | |

## Claims

1. A substrate processing apparatus comprising:
a vessel in which a substrate is processed;
a plasma generator comprising:
an electrode provided on an outer periphery of the vessel, wherein a high frequency power is applied to the electrode;
a power supply line connected to the electrode; and
a supplier configured to supply the high frequency power to the electrode via the power supply line;
a shield provided on an outer periphery of the electrode and configured to shield an electromagnetic wave emitted from the electrode;
an opening provided at the shield, wherein the power supply line is inserted through the opening;
a plurality of shielding structures provided to overlap with one another around the opening and around locations of the supplier facing the opening; and
a controller configured to be capable of controlling the plasma generator to move relative to the shield.

2. The substrate processing apparatus of claim 1, further comprising
a mover configured to move the plasma generator as an integrated body,
wherein the controller is further configured to be capable of controlling an operation of the mover.

3. The substrate processing apparatus of claim 1 and/or 2, wherein the plurality of shielding structures comprise an opening shielding structure provided at a periphery of the opening and configured to extend along the power supply line toward the supplier.

4. The substrate processing apparatus of any one or more of claims 1 to 3, wherein the plurality of shielding structures comprise a plurality of power supply shielding structures provided at the locations of the supplier facing the opening and configured to extend along the power supply line toward the shield.

5. The substrate processing apparatus of claim 4, wherein the plurality of power supply shielding structures comprise a first power supply shielding structure surrounded by an inner surface of the opening shielding structure.

6. The substrate processing apparatus of claim 4 and/or 5, wherein the plurality of power supply shielding structures comprise a second power supply shielding structure surrounding an outer surface of the opening shielding structure.

7. The substrate processing apparatus of any one or more of claims 1 to 6, wherein the plurality of shielding structures are arranged with a gap therebetween.

8. The substrate processing apparatus of any one or more of claims 4 to 7, wherein each of the plurality of power supply shielding structures is configured as a part of a housing of the supplier.

9. The substrate processing apparatus of any one or more of claims 1 to 8, wherein the controller is further configured to be capable of controlling the plasma generator to move in a horizontal direction with respect to the opening.

10. The substrate processing apparatus of any one or more of claims 3 to 9, wherein the opening shielding structure is configured such that a position of the opening shielding structure relative to the plasma generator is fixed.

11. The substrate processing apparatus of any one or more of claims 1 to 10, wherein the shield is configured such that a position of the shield relative to the plasma generator is fixed.

12. The substrate processing apparatus of any one or more of claims 1 to 11, wherein a horizontal width of a gap between a shielding structure among the plurality of shielding structures provided at the supplier and a shielding structure among the plurality of shielding structures provided around the opening is larger than a distance of a movement of the plasma generator in a direction parallel to an opening surface of the opening.

13. A method of adjusting an electromagnetic wave shield, comprising:
adjusting positions of a plurality of shielding structures such that an electromagnetic wave emitted from an electrode is shielded by the plurality of shielding structures by moving a plasma generator relative to a shield,
wherein the plasma generator comprises:
the electrode provided on an outer periphery of a vessel in which a substrate is processed, wherein a high frequency power is applied to the electrode;
a power supply line connected to the electrode; and
a supplier configured to supply the high frequency power to the electrode via the power supply line, and
wherein the shield is provided on an outer periphery of the electrode and configured to shield the electromagnetic wave emitted from the electrode, an opening is provided at the shield, the power supply line is inserted through the opening, and the plurality of shielding structures are provided to overlap with one another around the opening and around locations of the supplier facing the opening.

14. A method of manufacturing a semiconductor device, comprising:
(a) adjusting positions of a plurality of shielding structures such that an electromagnetic wave emitted from an electrode is shielded by the plurality of shielding structures by moving a plasma generator relative to a shield,
wherein the plasma generator comprises:
the electrode provided on an outer periphery of a vessel in which a substrate is processed, wherein a high frequency power is applied to the electrode;
a power supply line connected to the electrode; and
a supplier configured to supply the high frequency power to the electrode via the power supply line, and
wherein the shield is provided on an outer periphery of the electrode and configured to shield the electromagnetic wave emitted from the electrode, an opening is provided at the shield, the power supply line is inserted through the opening, the plurality of shielding structures are provided to overlap with one another around the opening and around locations of the supplier facing the opening; and
(b) processing the substrate.

15. A program that causes a substrate processing apparatus, by a computer, to perform:
(a) adjusting positions of a plurality of shielding structures such that an electromagnetic wave emitted from an electrode is shielded by the plurality of shielding structures by moving a plasma generator relative to a shield,
wherein the plasma generator comprises:
the electrode provided on an outer periphery of a vessel in which a substrate is processed, wherein a high frequency power is applied to the electrode;
a power supply line connected to the electrode; and
a supplier configured to supply the high frequency power to the electrode via the power supply line, and
wherein the shield is provided on an outer periphery of the electrode and configured to shield the electromagnetic wave emitted from the electrode, an opening is provided at the shield, the power supply line is inserted through the opening, the plurality of shielding structures are provided to overlap with one another around the opening and around locations of the supplier facing the opening; and
(b) processing the substrate.
